# EUROPÄISCHE PATENTSCHRIFT

(11) **EP 0 464 507 B1**
(45) Veröffentlichungstag und Bekanntmachung des Hinweises auf die Patenterteilung: **20.03.1996**
(21) Anmeldenummer: 91110216.8
(22) Anmeldetag: 21.06.1991
(51) Int. Cl.: B32B 31/18, B30B 5/06, B29C 65/02

(54) **Verfahren und Vorrichtung zum kontinuierlichen Herstellen von ebenen, Harz enthaltenden, plattenförmigen, mehrschichtigen Werkstoffen und Laminaten**
Method and apparatus for the continuous manufacture of planar, resin containing laminates
Procédé et dispositif pour la fabrication en continu de laminés planaires contenant une résine

(30) Priorität: 04.07.1990 DE 4021341
(43) Veröffentlichungstag der Anmeldung: 08.01.1992
(73) Patentinhaber: Firma Theodor Hymmen, D-33515 Bielefeld (DE)
(72) Erfinder:
(74) Vertreter: Stracke, Alexander, Dipl.-Ing.

(56) Entgegenhaltungen:
- EP-A- 0 061 352
- DE-A- 1 629 219
- DE-A- 1 704 152
- DE-A- 2 013 063
- DE-A- 3 347 877

## Beschreibung

Die Erfindung bezieht sich auf ein Verfahren und auf eine Vorrichtung zum kontinuierlichen Herstellen von ebenen, Harz enthaltenden, plattenförmigen, mehrschichtigen Werkstoffen und Laminaten, bei denen Preßgutschichten unter Druck und Wärme verflüssigt und ausgehärtet werden.

Es ist eine kontinuierlich arbeitende Presse mit einem oberen und einem unteren über einen jeweils ein Umlenkrollenpaar geführten Preßband bekannt (DE-PS 33 47 877), zwischen deren einander zugewandten Trums eine Werkstoffbahn, beispielsweise Laminate, Elektrolaminate, dünne Spanplatten, Faserplatten, Sperrholz o.dgl. unter Druckeinwirkung verdichtet werden kann. Bei dieser Doppelbandpresse sind die einander gegenüberliegenden Preßbänder an ihren Rändern einander gegenüberliegend mit Nuten ausgestattet, in die ein Draht eingelegt ist, dessen Durchmesser ungefähr so groß ist wie die Summe aus der zweifachen Tiefe der Nut und dem Abstand der beiden Preßbänder voneinander.

In der Reaktionszone der Doppelbandpresse, die nach oben und unten durch Preßbänder, nach vorn in Laufrichtung durch gehärtetes Harz und nach hinten durch ungeschmolzenes Harz abgeschlossen ist, verlaufen die Drähte in Abstand von den Längsrändern der übereinander liegenden Preßgutschichten, so daß flüssiges Harz im Längsseitenbereich austreten kann und den Raum zwischen den Längsseitenflächen des Preßgutes und den Drähten ausfüllt, wobei die Dickentoleranz des Preßgutes im Längsrandbereich beeinträchtigt wird.

Bei der bekannten Ausführung ist eine flüssigkeitsdichte Verbindung zwischen den Preßbändern und den teilweise in Nuten eingreifenden Drähten nicht gewährleistet, so daß flüssiges Harz aus dem Preßgut nicht nur in den Raum zwischen dem Preßgut und dem jeweiligen Draht, sondern auch durch einen Spalt zwischen dem Draht und den Preßbändern nach außen gedrückt werden kann. Dies beeinflußt weiterhin die Dickentoleranz des Preßgutes in den Randzonen negativ.

Es kommt hinzu, daß bei der bekannten Doppelbandpresse nicht nur die Preßbänder mit einer Nut versehen werden müssen, sondern daß auch die Drähte jeweils der Preßgutdicke angepaßt werden müssen.

Der Erfindung liegt die Aufgabe zugrunde, ein Verfahren der eingangs genannten Art so zu gestalten, daß während des Verpressens der Preßgutschichten ein Austritt einer flüssigen Materialphase aus dem Preßgut sicher vermieden wird.

Diese Aufgabe wird erfindungsgemäß dadurch gelöst, daß die frei liegenden Ränder der übereinander angeordneten Preßgutschichten miteinander verschweißt und anschließend das Preßgut unter Druck- und Wärmebelastung zur Verbundplatte oder Verbundbahn geformt wird. Die Verschweißung kann durch Laserstrahlen vorgenommen werden.

Bei einer vorteilhaften Ausführungsform des erfindungsgemäßen Verfahrens werden gleichzeitig mit dem Verschweißen der freien Ränder der Preßgutschichten diese durch die Laser-Strahlen bündig geschnitten.

Bei einer Vorrichtung zur Durchführung des erfindungsgemäßen Verfahrens zum kontinuierlichen Herstellen von ebenen, Harz enthaltenden, plattenförmigen, mehrschichtigen Werkstoffen und Laminaten unter Verwendung einer Bandpresse, vorzugsweise einer Doppelbandpresse ist der Laserkopf unmittelbar vor dem Einlauf der Preßgutschichten in den Preßspalt angeordnet. Durch die im Laserkopf erzeugten Laserstrahlen werden die parallel zur Durchlaufrichtung des Preßgutes verlaufenden, freien, übereinander liegenden Längsränder jeweils miteinander verschweißt.

Beim erfindungsgemäßen Verfahren bzw. bei der erfindungsgemäßen Vorrichtung kann somit auf Seitenabgrenzungskörper zur seitlichen Abdichtung der von den Trums gebildeten Preßzone und auch auf Anpassungen dieser Seitenabgrenzungskörper bei einem Wechsel der Preßgutdicke verzichtet werden.

Durch die Verschweißung der übereinander liegenden Preßgutschichten an den freien Rändern vor dem Aufbringen des Preßdruckes in der Reaktionszone werden in der Reaktionszone über den gesamten Querschnitt des Preßgutes gleiche Betriebsbedingungen geschaffen, die die Voraussetzung für ein Einhalten enger Fertigungstoleranzen für das Endprodukt bilden. Eine Besäumung der Werkstoffbahn nach dem Verlassen der Reaktionszone der Presse kann entfallen.

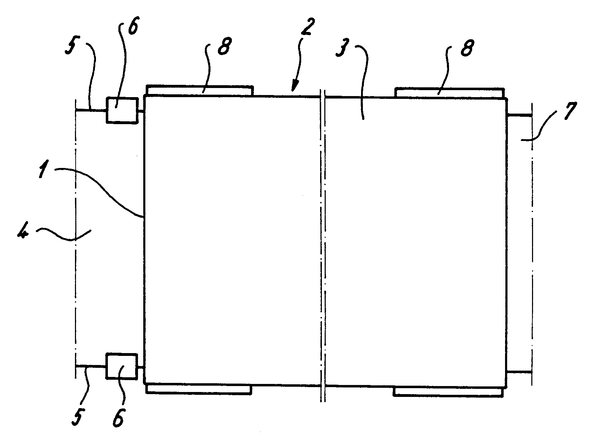

Eine mit einer Doppelbandpresse ausgerüstete Vorrichtung zur Durchführung des erfindungsgemäßen Verfahrens ist in der Zeichnung in ihren wesentlichen Funktionsteilen im Grundriß dargestellt.

Dem Einlauf 1 der Doppelbandpresse 2, die angetriebene, endlose Preßbänder 3 aufweist, werden mehrere Bahnen 4, die mit einem wärmehärtenden Kunstharzsystem ausgerüstet sind, zugeführt und gelangen in die Wirkzone der Doppelbandpresse, in der die Bahnen mit Druck und Temperatur beaufschlagt werden.

Im Bereich des Einlaufs 1 ist den übereinanderliegenden und fluchtenden Längsrändern 5 der Bahnen 4 jeweils ein Laserkopf 6 zugeordnet, durch dessen Strahlen die übereinanderliegenden Längsränder miteinander verschweißt werden. Hierdurch wird erreicht, daß beim Durchlaufen der Wirkzone im Bereich der Längsränder kein Harz nach außen austritt.

Mittels der Laserstrahlen kann auch eine Längsrandbesäumung der Bahnen 4 vorgenommen werden.

Aus der Reaktionszone bzw. Wirkzone wird die fertige Verbundbahn 7 gefördert und weiterverarbeitet.

Die Preßbänder 3 umlaufen Walzen 8 und fördern das Preßgut zum Austragende.

## Patentansprüche

1. Verfahren zum kontinuierlichen Herstellen von ebenen, Harz enthaltenden, plattenförmigen, mehrschichtigen Werkstoffen und Laminaten (4) unter Verwendung einer kontinuierlich arbeitenden Presse (2), bei denen Harz enthaltende Preßgutschichten in der Wirkzone der Presse unter Druck und Wärme verflüssigt und ausgehärtet werden, **dadurch gekennzeichnet,** daß die parallel zur Durchlaufrichtung des Preßgutes verlaufenden, frei liegenden Ränder (5) der übereinander angeordneten Preßgutschichten kontinuierlich miteinander verschweißt werden und anschließend das Preßgut unter Druck- und Wärmebelastung unter Vermeidung eines längsseitigen Harzaustrittes zur Verbundplatte oder Verbundbahn geformt wird.

2. Verfahren nach Anspruch 1, dadurch gekennzeichnet, daß die Verschweißung durch Laserstrahlen vorgenommen wird.

3. Verfahren nach Anspruch 2, dadurch gekennzeichnet, daß gleichzeitig mit dem Verschweißen der freien Ränder der Preßgutschichten diese durch die Laserstrahlen bündig geschnitten werden.

4. Vorrichtung zum Durchführen des Verfahrens nach Anspruch 2 oder 3 zum kontinuierlichen Herstellen von ebenen, Harz enthaltenden, plattenförmigen, mehrschichWerkstoffen und Laminaten (4) unter Verwendung einer Bandpresse (2), vorzugsweise einer Doppelbandpresse, dadurch gekennzeichnet, daß Laserköpfe (6) unmittelbar vor dem Einlauf der Preßgutschichten in den Preßspalt angeordnet sind und durch die in den Laserköpfen erzeugten Laserstrahlen die parallel zur Durchlaufrichtungdes Preßgutes verlaufenden, freien, übereinander liegenden Längsränder (5) jeweils miteinander verschweißbar sind.

## Claims

1. A process for continuously producing flat, resin-containing, plate-like, multi-layer materials and laminates (4) using a continuously operating press (2), in which resin-containing pressing material layers are liquefied in the operative region of the press under pressure and heat and hardened, characterised in that the eased edges (5), which extend parallel to the direction of movement of the pressing material through the press, of the pressing material layers which are disposed one above the other are continuously welded to each other and then the pressing material is shaped under a pressure and heat loading to form the composite plate or composite web, while preventing resin from escaping at the longitudinal sides.

2. A process according to claim 1 characterised in that the welding operation is effected by laser beams.

3. A process according to claim 2 characterised in that the free edges of the pressing material layers are cut flush by the laser beams simultaneously with the operation of welding the free edges.

4. Apparatus for carrying out the process according to claim 2 or claim 3 for continuously producing flat, resin-containing, plate-like, multi-layer materials and laminates (4) using a belt press (2), preferably a double-belt press, characterised in that laser heads (6) are arranged immediately upstream of the entrance of the pressing material layers into the pressing gap and the free, superposed longitudinal edges (5) which extend parallel to the direction of movement of the pressing material through the apparatus can be respectively welded together by the laser beams generated in the laser heads.

## Revendications

1. Procédé de fabrication continue de matériaux à plusieurs couches, contenant de la résine, en forme de plaques planes et de stratifiés (4) par utilisation d'une presse (2) fonctionnant en continu, dans lesquels des couches de matériau pressé, contenant de la résine, sont fluidifiées et durcies sous l'effet d'une pression et de la chaleur, dans la zone active de la presse, caractérisé en ce que les bords libres (5), s'étendant parallèlement au sens de défilement du matériau à presser, des couches de matériau à presser superposées, sont soudés entre eux en continu et ensuite le matériau à presser est formé sous l'action d'une pression et de la chaleur en un panneau composite ou une bande composite, en évitant une sortie de résine sur les grands côtés.

2. Procédé selon la revendication 1, caractérisé en ce que le soudage est effectué au moyen de rayons laser.

3. Procédé selon la revendication 2, caractérisé en ce qu'en même temps que le soudage des bords libres des couches du matériau à presser, ceux-ci sont coupés à vif par les rayons laser.

4. Dispositif pour la mise en oeuvre du procédé selon la revendication 2 ou 3 pour la fabrication en continu de matériaux à plusieurs couches, contenant de la résine, en forme de plaques planes et de stratifiés (4), par utilisation d'une presse à bande (2), de préférence une presse à double bande, caractérisé en ce que des têtes laser (6) sont placées directement devant l'entrée des couches de matériau à presser dans la fente de la presse, les bords longitudinaux (5) superposés, libres, s'étendant parallèlement à la direction de défilement du matériau à presser, pouvant être soudés entre eux par les rayons laser produits par les têtes laser.
